# EUROPÄISCHE PATENTANMELDUNG

(11) **EP 3 745 830 A1**
(43) Veröffentlichungstag der Anmeldung: **02.12.2020**
(21) Anmeldenummer: 20162083.8
(22) Anmeldetag: 10.03.2020
(51) Int. Cl.: H05K 1/02, H02M 7/00, H02M 1/00, H05K 1/18, G01R 1/20, H01C 1/144

(54) **ANORDNUNG MIT EINEM LEISTUNGSELEKTRONIKSUBSTRAT UND EINEM KONTAKTELEMENT, LEISTUNGSELEKTRONIKEINHEIT UND STROMRICHTER**

(30) Priorität: 29.05.2019 DE 102019114524
(71) Anmelder: Valeo Siemens eAutomotive Germany GmbH, 91056 Erlangen (DE)
(72) Erfinder: BAUMANN, Mathias, 08056 Zwickau (DE); THIEMANN, Stefan, 91052 Erlangen (DE)
(74) Vertreter: Dr. Gassner & Partner mbB

(57) **Zusammenfassung**

Anordnung (1) mit einem Leistungselektroniksubstrat (2), welches eine elektrisch isolierende Grundplatte (4) und eine auf einer Seite (5) der Grundplatte (4) angeordnete elektrisch leitfähige Oberflächenschicht (6) aufweist, und mit einem Kontaktelement (3), dessen erstes Ende (10) elektrisch leitend mit der Oberflächenschicht (6) verbunden ist und dessen zweites Ende (11) mit einem elektrischen Leiter (9) verbindbar oder verbunden ist, wobei das Kontaktelement (3) aus einer Widerstandslegierung gebildet ist.

## Beschreibung

Die vorliegende Erfindung betrifft eine Anordnung mit einem Leistungselektroniksubstrat, welches eine elektrisch isolierende Grundplatte und eine auf einer Seite der Grundplatte angeordnete elektrisch leitfähige Oberflächenschicht aufweist, und mit einem Kontaktelement, dessen erstes Ende elektrisch leitend mit der Oberflächenschicht verbunden ist und dessen zweites Ende mit einem elektrischen Leiter verbindbar oder verbunden ist.

Daneben betrifft die Erfindung eine Leistungselektronikeinheit und einen Stromrichter.

Leistungselektroniksubstrate dienen der Aufnahme von Leistungshalbleiterbauelementen und zeichnen sich insbesondere durch eine hohe Wärmebeständigkeit, eine hohe Isolationsfähigkeit und ein hohes Wärmeableitvermögen aus. Ein Beispiel für ein solches Leistungselektroniksubstrat ist eine DCB (Direct Copper Bonded), welches eine elektrisch isolierende Grundplatte aus einem keramischen Material und eine auf einer Seite der Grundplatte angeordnete elektrisch leitfähige Oberflächenschicht aus Kupfer aufweist. Ein solches Leistungselektroniksubstrat wird typischerweise mittels eines Kontaktelements mit einem elektrischen Leiter, beispielsweise einer Stromschiene verbunden.

Beim Einsatz solcher Anordnungen, beispielsweise bei einem Betrieb in einem Stromrichter, kann eine Strommessung erforderlich sein. Zu diesem Zweck werden häufig Shunts (Nebenschlusswiderstände) eingesetzt. Es ist bekannt, Shunts als Bauteil auf einer DCB anzuordnen. Derartige Shunts nehmen als separates Bauteil einen großen Bauraum in Anspruch und erwärmen sich stark, was einen zusätzlichen Aufwand für die Kühlung des Shunts nach sich zieht.

Der Erfindung liegt daher die Aufgabe zugrunde, eine Möglichkeit zur Strommessung auf dem Gebiet der Leistungselektronik anzugeben, die aufwandsarm und bauraumsparend realisierbar ist.

Diese Aufgabe wird erfindungsgemäß bei einer Anordnung der eingangs genannten Art dadurch gelöst, dass das Kontaktelement aus einer Widerstandslegierung gebildet ist.

Die Erfindung beruht auf der Überlegung, das Kontaktelement zum Verbinden des Leistungselektroniksubstrat mit dem elektrischen Leiter aus der Widerstandslegierung zu bilden, die sich typischerweise auch als Material zur Herstellung eines Shunts eignet. Es kann dadurch auf als separate Bauteile ausgebildete Shunts verzichtet und eine unmittelbare Integration des Shunts in das Kontaktelement realisiert werden. Dem Kontaktelement wird so ein zusätzlicher Nutzwert verliehen, da es gleichzeitig als Shunt benutzt werden kann.

Mithin entfällt der zusätzliche Bauraum für als separate Bauelemente ausgebildete Shunts. Ferner kann eine in der Praxis ohnehin häufig vorgesehene Kühlung des Leistungselektroniksubstrat für die Kühlung des Kontaktelements ohne zusätzliche Maßnahmen mitgenutzt werden. Eine zusätzliche Kühlstruktur für einen Shunt entfällt so. Die erfindungsgemäße Anordnung ermöglich daher vorteilhafterweise eine bauraumsparende und aufwandsarm realisierbare Strommessung.

Typischerweise sind in der Oberflächenschicht Leiterbahnen ausgebildet. Dies kann beispielsweise durch Ätzen erfolgen. Zwischen zwei benachbarten Leiterbahnen ist zweckmäßigerweise eine Ausnehmung in der Oberflächenschicht ausgebildet. Das Leistungselektroniksubstrat kann ferner eine zweite Oberflächenschicht auf einer der ersten Seite der Grundplatte gegenüberliegenden zweiten Seite aufweisen. Sämtliche Ausführungen zur ersten Oberflächenschicht lassen sich auch auf die zweite Oberflächenschicht übertragen.

Die Widerstandslegierung zeichnet sich zweckmäßigerweise durch einen über weite Temperaturbereiche geringen linearen Widerstandstemperaturkoeffizienten aus, der insbesondere geringer als jener von Kupfer ist. Es wird bei der erfindungsgemäßen Anordnung bevorzugt, wenn der lineare Widerstandstemperaturkoeffizient der Widerstandslegierung in einem Temperaturbereich zwischen 20 °C und 105 °C betragsmäßig nicht größer als 1,0 · 10⁻³ K⁻¹, bevorzugt nicht größer als 1,0 · 10⁻⁴ K⁻¹ ist.

Hinsichtlich des Materials der Widerstandslegierung wird es bei der erfindungsgemäßen Anordnung bevorzugt, wenn die Widerstandslegierung eine Legierung mit mindestens 50 Gew.-% Kupfer und wenigstens 5 Gew.-% und höchstens 25 Gew.-% Mangan ist. Die Legierung kann ferner wenigstens 0,1 Gew.-% und/oder höchstens 5 Gew.-% Nickel und/oder wenigstens 0,5 Gew.-% und/oder höchstens 5 Gew.-% Aluminium aufweisen. Typische Widerstandslegierungen auf Basis von Kupfer sind beispielsweise CuMn13AI (Isabellin®) oder CuMn12Ni (Manganin®).

Alternativ kann bei der erfindungsgemäßen Anordnung vorgesehen sein, dass die Widerstandslegierung eine Legierung mit mindestens 50 Gew.-% Nickel und wenigstens 5 Gew.-% und höchstens 30 Gew.-% Chrom ist. Eine typische Widerstandslegierungen auf Basis von Nickel ist beispielsweise NiCr20AlSi (Isaohm®).

Bevorzugterweise ist das Kontaktelement als Flachdraht ausgebildet.

Bei der erfindungsgemäßen Anordnung ist es von Vorteil, wenn das erste Ende des Kontaktelements und die Oberflächenschicht eine Bondverbindung ausbilden. Ebenso kann vorgesehen sein, dass das zweite Ende des Kontaktelements und der elektrische Leiter eine Bondverbindung ausbilden. Derartige Bondverbindungen sind zuverlässig mittels Ultraschallschweißen herstellbar.

Es wird besonders bevorzugt, wenn ein elektrisch mit dem ersten Ende des Kontaktelements verbundener Messkontakt auf der Oberflächenschicht ausgebildet ist. Ein solcher Messkontakt erlaubt leistungselektroniksubstratseitig ein Abgreifen eines Potentials einer Shuntspannung zur Ermittlung einer Stromstärke eines elektrischen Stroms durch das Kontaktelement.

Die erfindungsgemäße Anordnung kann selbstverständlich auch den mit dem zweiten Ende des Kontaktelements elektrisch leitend verbundenen elektrischen Leiter umfassen.

Dann wird es bevorzugt, wenn auf dem Leiter ein mit dem zweiten Ende des Kontaktelements elektrisch leitend verbundener Messkontakt ausgebildet ist. Dieser Messkontakt ermöglicht mithin den leiterseitigen Abgriff des anderen Potentials der Shuntspannung.

Der Leiter ist ferner bevorzugt eine Stromschiene.

Bevorzugt sind ein oder mehrere weitere Kontaktelemente vorgesehen, die parallel zum ersten Kontaktelement geschaltet sind. Auf die weiteren Kontaktelemente sind sämtliche Ausführungen zum ersten Kontaktelement analog übertragbar.

Es wird grundsätzlich bevorzugt, wenn die Grundplatte aus einem keramischen Material gebildet ist. Dann können durch das Leistungselektroniksubstrat wesentliche Vorteile einer DCB realisiert werden. Alternativ kann die Grundplatte eine Metallplatte mit einer ein keramisches Material umfassenden dielektrischen Schicht umfassen. In diesem Fall ist die Struktur der Grundplatte im Wesentlichen der eines isolierten Metallsubstrats angenähert. Die Metallplatte kann aus Aluminium gebildet sein. Die dielektrische Schicht kann ein mit Keramikpulver gefülltes Polymer umfassen.

Es ist außerdem vorteilhaft, wenn die erfindungsgemäße Anordnung wenigstens einen Leistungshalbleiter aufweist, die elektrisch leitend mit der Oberflächenschicht des Leistungselektroniksubstrats verbunden ist. Das Leistungselektroniksubstrat und Leistungshalbleiter können dann als Leistungselektronikmodul aufgefasst werden.

Zweckmäßigerweise umfasst die Leistungshalbleiteranordnung einen oder mehrere Leistungstransistoren. Außerdem kann die Leistungshalbleiteranordnung eine oder mehrere Dioden umfassen, die insbesondere antiparallel zu den Leistungstransistoren geschaltet ist oder sind. Typischerweise bildet die Leistungshalbleiteranordnung eine Halbbrücke aus. Bevorzugt ist die elektrisch leitende Verbindung zwischen dem Leistungselektroniksubstrat und der Leistungshalbleiteranordnung durch einen oder mehrere Bonddrähte realisiert. Die Leistungshalbleiteranordnung kann mittels einer Verbindungsschicht, beispielsweise einer Lot- oder Sinterschicht, auf dem Leistungselektroniksubstrat befestigt sein.

Daneben wird die der Erfindung zugrundeliegende Aufgabe durch eine Leistungselektronikeinheit, umfassend mehrere jeweils die Leistungshalbleiteranordnung umfassende Anordnungen, gelöst.

Die erfindungsgemäße Leistungselektronikeinheit oder die erfindungsgemäße Anordnung kann ferner eine Basisplatte aufweisen, auf welcher das oder die Leistungselektroniksubstrate mit der der Leistungshalbleiteranordnung gegenüberliegenden Seite, insbesondere mittels einer Kontaktschicht, beispielsweise einer Lot- oder Sinterschicht, befestigt sein können. Ferner kann die Leistungselektronikeinheit oder die Anordnung eine Wärmesenke aufweisen, auf welcher die Basisplatte mit ihrer dem Leistungselektroniksubstrat gegenüberliegenden Seite, insbesondere über eine Wärmeleitschicht, angeordnet ist.

Daneben wird die der Erfindung zugrundeliegende Aufgabe durch einen Stromrichter gelöst, umfassend eine die Leistungshalbleiteranordnung aufweisende Anordnung oder eine erfindungsgemäße Leistungselektronikeinheit, wobei der Stromrichter eine Steuereinrichtung aufweist, die dazu eingerichtet ist, die wenigstens eine Leistungshalbleiteranordnung zur Leistungswandlung anzusteuern. Bevorzugt ist der Stromrichter als Wechselrichter, insbesondere für einen Antrieb eines Fahrzeugs, ausgebildet. Der Stromrichter kann aber auch als Gleichrichter oder Umrichter oder Gleichspannungswandler ausgebildet sein.

Sämtliche Ausführungen zur erfindungsgemäßen Anordnung lassen sich analog auf die erfindungsgemäße Leistungselektronikeinheit und den erfindungsgemäßen Stromrichter übertragen, so dass auch mit diesen die zuvor beschriebenen Vorteile erzielt werden können.

Weitere Einzelheiten und Vorteile der vorliegenden Erfindung ergeben sich aus den im Folgenden beschriebenen Ausführungsbeispielen sowie anhand der Zeichnungen. Diese sind schematische Darstellungen und zeigen:
- Fig. 1: eine ausschnittsweise Prinzipskizze eines Querschnitts eines Ausführungsbeispiels der erfindungsgemäßen Anordnung;
- Fig. 2: eine Draufsicht auf das in Fig. 1 gezeigte Ausführungsbeispiel;
- Fig. 3: eine Prinzipskizze eines Querschnitts eines Ausführungsbeispiels des erfindungsgemäßen Leistungselektronikeinheit; und
- Fig. 4: ein Blockschaltbild eines Ausführungsbeispiels eines erfindungsgemäßen Stromrichters.

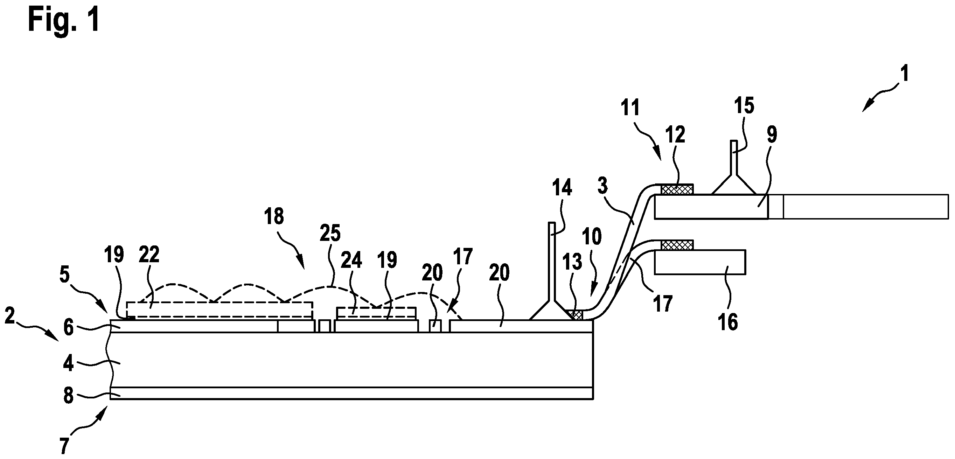

Fig. 1 ist eine Prinzipskizze eines Querschnitts eines Ausführungsbeispiels einer Anordnung 1 mit einem Leistungselektroniksubstrat 2 und mehreren parallel geschalteten Kontaktelementen 3, wovon in Fig. 1 nur eines sichtbar ist.

Das Leistungselektroniksubstrat 2 weist eine elektrische isolierende Grundplatte 4 und eine auf einer ersten Seite 5 der Grundplatte 4 angeordnete elektrisch leitfähige erste Oberflächenschicht 6 auf. Daneben umfasst das Leistungselektroniksubstrat 2 ferner auf einer der ersten Seite 5 gegenüberliegenden zweiten Seite 7 der Grundplatte 4 eine zweite elektrisch leitfähige Oberflächenschicht 8. Die Oberflächenschichten 6, 8 sind aus Kupfer oder aus einer wenigstens 95 Gew.-% Kupfer umfassenden Legierung gebildet.

Die Kontaktelemente 3 sind aus Flachdraht gebildet und in einem mit einem elektrischen Leiter 9 der Anordnung 1 elektrisch leitend verbundenen Zustand gezeigt. Der Leiter 9 ist eine Stromschiene. Ein erstes Ende 10 eines jeweiligen Kontaktelements 3 ist elektrisch leitend mit der ersten Oberflächenschicht 6 verbunden. Ein zweites Ende 11 eines jeweiligen Kontaktelements 3 ist elektrischen leitend mit dem Leiter 9 verbunden. Die Verbindungen der Enden 10, 11 mit der ersten Oberflächenschicht 6 bzw. mit dem Leiter 9 sind durch Bondverbindungen 12, 13 realisiert, die durch Ultraschallschweißen erzeugt worden sind. Insofern können die Kontaktelemente auch als Bonddrähte aufgefasst werden.

Die Kontaktelemente 3 sind aus einer Widerstandslegierung gebildet, die sich dadurch auszeichnet, dass ihr linearer Widerstandstemperaturkoeffizient in einem Temperaturbereich zwischen 20 °C und 105 °C betragsmäßig nicht größer als 0,1 · 10⁻³ K⁻¹ ist. Das Material der Widerstandslegierung ist eine Kupferlegierung mit mindestens 50 Gew.-% Kupfer und mit zwischen 5 und 25 Gew.-% Mangan. Weitere Bestandteile können Nickel und/oder Aluminium sein. Die Widerstandslegierung ist im vorliegenden Ausführungsbeispiel CuMn13Al (Isabellin®) oder CuMn12Ni (Manganin®). Gemäß einem alternativen Ausführungsbeispiel ist die Widerstandslegierung eine Nickellegierung mit mindestens 50 Gew.-% Nickel und zwischen 5 und 30 Gew.-% Chrom, wie beispielsweise in NiCr20AlSi (IsaOhm®).

Die Anordnung 1 weist ferner einen ersten Messkontakt 14, der in der Nähe des erstes Endes 10 angeordnet ist, und einen zweiten Messkontakt 15, der in der Nähe des zweiten Endes 11 angeordnet ist, auf. Die Messkontakte 14, 15 sind elektrisch leitend mit den Enden 10, 11 verbunden. Werden die Kontaktelemente 3 von einem elektrischen Strom durchflossen, so fällt über ihnen eine Shuntspannung ab, die unter Berücksichtigung des Widerstands der Kontaktelemente 3 und der Position der Messkontakte 14, 15 zur Ermittlung der Stromstärke des elektrischen Stroms verwendet werden kann. Dadurch kann auf herkömmlicherweise vorgesehene Shunts als separate Bauelemente verzichtet werden, da durch die Ausbildung der Kontaktelemente 3 aus der Widerstandslegierung eine Integration des Shunts in die Anordnung 1 realisiert wird.

Die Anordnung 1 weist einen weiteren elektrischen Leiter 16 auf, der über weitere Kontaktelemente 17, von denen in Fig. 1 ebenfalls nur eines sichtbar ist, in analoger Weise zu den Kontaktelementen 3 mit der ersten Oberflächenschicht 6 verbunden ist. Die Kontaktelemente 17 ist aus Kupfer gebildet und dient nicht als Shunt. Es ist aber grundsätzlich auch denkbar, die Kontaktelemente 17 wie die Kontaktelemente 3 auszubilden und analog für eine Strommessung zu verwenden.

Die Grundplatte 4 des Leistungselektroniksubstrat 2 ist aus einem keramischen Material gebildet. Die Struktur des Leistungselektroniksubstrats 2 entspricht so grundsätzlich einer DCB (Direct Copper Bonded). Gemäß einem alternativen Ausführungsbeispiel umfasst die Grundplatte eine Metallplatte, die auf mindestens einer Seite von einer dielektrischen Schicht umschlossen ist. Insofern bildet das Leistungselektroniksubstrat 2 dann die Grundstruktur eines isolierten Metallsubstrat ab.

Daneben weist die Anordnung 1 eine in Fig. 1 teilweise sichtbare Leistungshalbleiteranordnung 18 auf, die über eine Verbindungsschicht 19, beispielsweise einer Lot- oder Sinterschicht, an der ersten Oberflächenschicht 6 des Leistungselektroniksubstrats 2 befestigt ist.

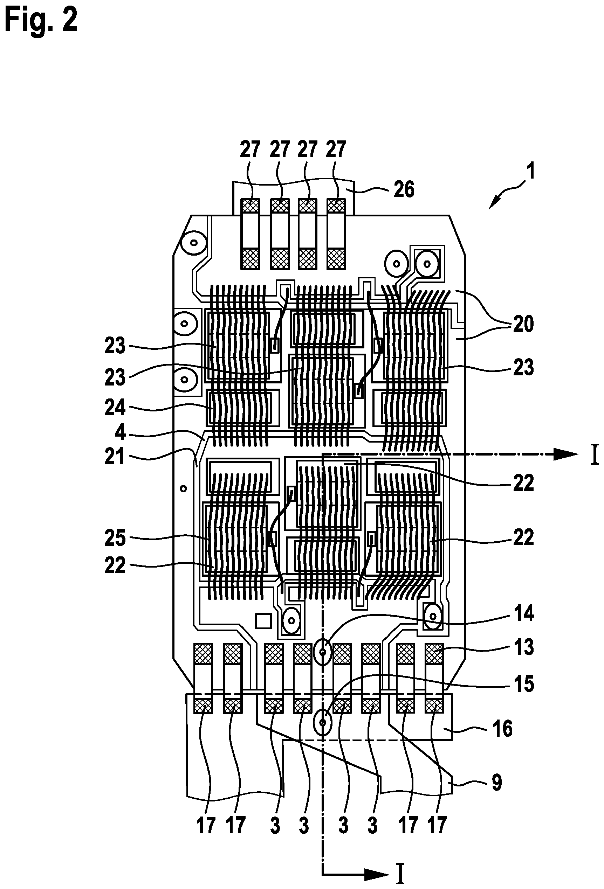

Fig. 2 ist eine Draufsicht auf die in Fig. 1 gezeigte Anordnung 1, wobei eine Schnittlinie I-I den in Fig. 1 gezeigten Querschnitt kennzeichnet.

Ersichtlich sind eine Vielzahl von Leiterbahnen 20 auf der ersten Seite 5 des Leistungselektroniksubstrat 2 ausgebildet. Zwischen zwei benachbarten Leiterbahnen 20 sind Ausnehmungen 21 der ersten Oberflächenschicht 6 durch Ätzen ausgebildet und legen die Grundplatte 4 frei.

Die Leistungshalbleiteranordnung 18 umfasst in dem vorliegenden Ausführungsbeispiel drei parallel geschaltete erste Leistungstransistoren 22 sowie drei ebenfalls parallel geschaltete zweite Leistungstransistoren 23, die mit den ersten Leistungstransistoren 22 so verschaltet sind, dass sie eine Halbbrücke ausbilden. Die Leistungstransistoren 22, 23 sind beispielsweise jeweils ein Bipolartransistor mit isoliertem Gate (IGBT) oder ein Leistungs-MOSFET. Daneben weist die Leistungshalbleiteranordnung 3 mehrere antiparallel zu einem jeweiligen Leistungstransistor 22, 23 geschaltete Dioden 24 auf. Die Leistungshalbleiteranordnung 3 bzw. die Leistungstransistoren 22, 23 und die Dioden 24 sind durch Bonddrähte 25 untereinander und mit den Leiterbahnen 20 der ersten Oberflächenschicht 6 elektrisch leitend verbunden. Es ist darauf hinzuweisen, dass die Bonddrähte 25 wesentlich dünner als die Kontaktelemente 3 sind.

Die Anordnung 1 weist außerdem eine weiteren, ebenfalls als Stromschiene ausgebildeten elektrischen Leiter 26 auf, der über weitere Kontaktelemente 27 mit der ersten Oberflächenschicht 6 elektrisch leitend verbunden ist. Gemäß weiteren Ausführungsbeispielen sind die Kontaktelemente 27 anstelle oder zusätzlich zu den Kontaktelementen 3 aus der Widerstandslegierung gebildet und die oder weitere Messelemente im Bereich der Kontaktelemente 27 vorgesehen. Insofern lassen sich alle bisherigen Ausführungen auf die Kontaktelemente 27 übertragen.

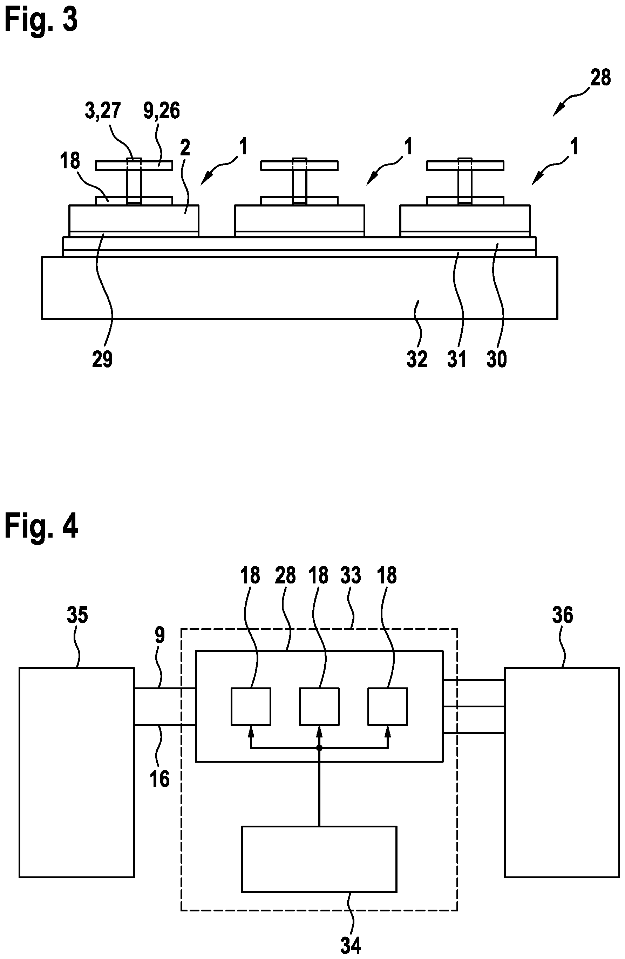

Fig. 3 ist eine Prinzipskizze eines Querschnitts eines Ausführungsbeispiels einer Leistungselektronikeinheit 28, die mehrere, vorliegend drei, Anordnungen 1 gemäß einem der zuvor beschriebenen Ausführungsbeispiele aufweist.

Jede Anordnung 1 ist in der Regel über die zweite Oberflächenschicht 8 mittels einer Kontaktschicht 29 (z.B. Lot- oder Sinterschicht) mit einer Basisplatte 30 verbunden, sofern diese vorhanden ist, die wiederum mittels einer aus einer Wärmeleitpaste gebildeten Wärmeleitschicht 31 mit einem Kühlkörper 32 verbunden ist.

Fig. 4 ist ein Blockschaltbild eines Ausführungsbeispiels eines Stromrichters 33, der die Leistungselektronikeinheit 28 gemäß Fig. 3 oder drei anderweitig angeordnete Anordnungen 1 nach einem der Ausführungsbeispiele gemäß Fig. 1 und Fig. 2 aufweist. Daneben umfasst der Stromrichter 33 eine Steuereinrichtung 34, die dazu eingerichtet ist, die Leistungshalbleiteranordnung 3 zur Leistungswandlung anzusteuern.

Exemplarisch ist der Stromrichter 33 hier als Wechselrichter gezeigt, der eine von einer Gleichspannungsquelle 35 über die elektrischen Leiter 9, 16 bereitgestellte Gleichspannung in eine dreiphasige Wechselspannung wandelt. Ausgangsseitig ist der Stromrichter 33 für jede Phase über den Leiter 26 mit einem elektrischen Verbraucher, beispielsweise einer elektrischen Antriebsmaschine 36 eines elektrisch antreibbaren Fahrzeugs, verbunden.

Gemäß weiteren Ausführungsbeispielen ist der Stromrichter als aktiver Gleichrichter, als Umrichter oder als Gleichspannungswandler ausgebildet.

## Patentansprüche

1. Anordnung (1) mit einem Leistungselektroniksubstrat (2), welches eine elektrisch isolierende Grundplatte (4) und eine auf einer Seite (5) der Grundplatte (4) angeordnete elektrisch leitfähige Oberflächenschicht (6) aufweist, und mit einem Kontaktelement (3), dessen erstes Ende (10) elektrisch leitend mit der Oberflächenschicht (6) verbunden ist und dessen zweites Ende (11) mit einem elektrischen Leiter (9) verbindbar oder verbunden ist, **dadurch gekennzeichnet, dass** das Kontaktelement (3) aus einer Widerstandslegierung gebildet ist.

2. Anordnung nach einem der vorhergehenden Ansprüche, wobei der lineare Widerstandstemperaturkoeffizient der Widerstandslegierung in einem Temperaturbereich zwischen 20 °C und 105 °C betragsmäßig nicht größer als 1,0 · 10⁻³ K⁻¹ ist, und/oder wobei die Widerstandslegierung eine Legierung mit mindestens 50 Gew.-% Kupfer und wenigstens 5 Gew.-% und höchstens 25 Gew.-% Mangan oder eine Legierung mit mindestens 50 Gew.-% Nickel und wenigstens 5 Gew.-% und höchstens 30 Gew.-% Chrom ist.

3. Anordnung nach einem der vorhergehenden Ansprüche, wobei das Kontaktelement (3) als Flachdraht ausgebildet ist.

4. Anordnung nach einem der vorhergehenden Ansprüche, wobei das erste Ende (10) des Kontaktelements (3) und die Oberflächenschicht (6) eine Bondverbindung (13) ausbilden.

5. Anordnung nach einem der vorhergehenden Ansprüche, wobei ein elektrisch mit dem ersten Ende (10) des Kontaktelements (3) verbundener Messkontakt (14) auf der Oberflächenschicht (6) ausgebildet ist.

6. Anordnung nach einem der vorhergehenden Ansprüche, ferner umfassend den mit dem zweiten Ende (11) des Kontaktelements (3) elektrisch leitend verbundenen elektrischen Leiter (9).

7. Anordnung nach Anspruch 6, wobei auf dem Leiter (9) ein mit dem zweiten Ende (11) des Kontaktelements (3) elektrisch leitend verbundener Messkontakt (15) ausgebildet ist.

8. Anordnung nach Anspruch 6 oder 7, wobei der Leiter (9) eine Stromschiene ist.

9. Anordnung nach einem der vorhergehenden Ansprüche, wobei die Grundplatte (4) aus einem keramischen Material gebildet ist oder eine Metallplatte mit einer ein keramisches Material umfassenden dielektrischen Schicht umfasst.

10. Anordnung nach einem der vorhergehenden Ansprüche, ferner umfassend wenigstens eine Leistungshalbleiteranordnung (18), die elektrisch leitend mit der Oberflächenschicht (6) des Leistungselektroniksubstrats (2) verbunden ist.

11. Leistungselektronikeinheit (28), umfassend mehrere Anordnungen (1) nach Anspruch 10.

12. Stromrichter (33), umfassend wenigstens eine Anordnung (1) nach Anspruch 10 oder eine Leistungselektronikeinheit (28) nach Anspruch 11, wobei der Stromrichter (33) eine Steuereinrichtung (34) aufweist, die dazu eingerichtet ist, die wenigstens eine Leistungshalbleiteranordnung (18) zur Leistungswandlung anzusteuern.
